# EUROPÄISCHE PATENTSCHRIFT

(11) **EP 2 717 275 B1**
(45) Veröffentlichungstag und Bekanntmachung des Hinweises auf die Patenterteilung: **11.03.2020**
(21) Anmeldenummer: 13187046.1
(22) Anmeldetag: 02.10.2013
(51) Int. Cl.: H01B 12/10, H01L 39/14, H01L 39/24

(54) **Verfahren zur Fertigung eines Supraleiterdrahts, insbesondere unter Verwendung bleifreier Lote**
Method for producing a superconductor wire, in particular using lead-free solder
Procédé de fabrication d'un fil supraconducteur, notamment en utilisant une brasure sans plomb

(30) Priorität: 05.10.2012 DE 102012218250
(43) Veröffentlichungstag der Anmeldung: 09.04.2014
(73) Patentinhaber: Bruker EAS GmbH, 63450 Hanau (DE)
(72) Erfinder: Prause, Burkhard, 63584 Gründau (DE); Thöner, Manfred, 63599 Biebergemünd (DE); Szulczyk, Andreas, 63589 Linsengericht (DE)
(74) Vertreter: Kohler Schmid Möbus Patentanwälte

(56) Entgegenhaltungen:
- EP-A1- 2 202 814
- DE-A1- 2 938 999
- DE-A1- 3 527 714
- GB-A- 1 130 464
- US-A- 4 554 407

## Beschreibung

Die Erfindung betrifft ein Verfahren zur Fertigung eines Supraleiterdrahts, wobei ein Innendraht, der supraleitende Filamente enthält, mit einer normalleitenden Stabilisierungsstruktur versehen wird,
wobei in einem kontinuierlichen oder quasi-kontinuierlichen Prozess ein oder mehrere Mantelelemente an den Innendraht angeformt und/oder angelegt werden, so dass der Innendraht über seinen gesamten Umfang von dem einen oder den mehreren Mantelelementen umhüllt wird, und wobei alle Nähte von einander gegenüberliegenden Mantelelement-Enden verlötet und/oder verschweißt werden.

Ein solches Verfahren ist aus der GB 1,130,464 bekannt geworden.

Ein anderes Verfahren, bei dem ein Innendraht, der supraleitende Filamente enthält, mit einer normalleitenden Stabilisierungsstruktur versehen wird, wird für die Fertigung von NbTi-Supraleiterdrähten des Typs "Wire in Channel" (Draht im Kanal) eingesetzt, vgl. beispielsweise das Bruker-Merkblatt "NbTi for MRI application", Seite 1 der Datei "NbTi wires.pdf", herunterladbar auf http://www.bruker-est.com/low-temperature-supercons.html am 1.10.2012.

Supraleiter können elektrische Ströme praktisch ohne ohmsche Verluste tragen. Supraleiterdrähte, die Supraleiterfilamente enthalten, werden insbesondere in Stromleitungen und Magnetspulen umfangreich eingesetzt; häufig verwendete metallische Supraleitermaterialien sind insbesondere NbTi und Nb₃Sn.

Supraleitung ist unter anderem durch eine kritische Temperatur und eine kritische Stromstärke begrenzt; beide Werte unterscheiden sich von Material zu Material. Werden die kritische Temperatur oder die kritische Stromstärke überschritten, kommt es in einem Supraleiterdraht zu einem plötzlichen Verlust der Supraleitung ("Quench"). Der elektrische Widerstand steigt stark an, was zu einem erheblichen Temperaturanstieg aufgrund nunmehr einsetzender ohmscher Verluste führt; dieser Temperaturanstieg kann den Supraleiterdraht beschädigen.

Es ist daher üblich, bei einem Supraleiterdraht parallel zu den supraleitenden Filamenten auch einen normalleitenden Strompfad mit einem ausreichend großen Querschnitt zur Verfügung zu stellen, um im Quenchfall den zuvor supraleitend getragenen Strom durch den normalleitenden Strompfad übernehmen zu können und so den lokalen Temperaturanstieg zu reduzieren bzw. weiter zu verteilen. Der normalleitende Strompfad wird auch als "Stabilisierung" bezeichnet; am häufigsten wird elementares Kupfer für die Stabilisierung eingesetzt.

Übliche Fertigungstechniken für Supraleiterdrähte, etwa mit NbTi-Filamenten, beruhen im Wesentlichen auf Strangpress- und Ziehtechniken, bei denen Kupfer-Matrixmaterial oder Kupfer-Hüllrohre zusammen mit Supraleitermaterial oder dessen Vorstufen, meist in Stangenform oder in Halbzeugen verarbeitet, verformt wird; gegebenenfalls können auch mehrere Bündel- und Ziehschritte kombiniert werden. Bei diesen Techniken ist der Kupferanteil im gezogenen Supraleiterdraht in der Regel durch Billetaufbau, Werkstoffkenngrößen/Spannungszustände beim Strangpressen und Ziehtechnik von Verbunden (Kernbruch-Problem) bestimmt. Insbesondere bei großen Drahtlängen kann mit herkömmlichen Ziehtechniken eine ausreichende Stabilisierung oftmals nicht durch den gezogenen Draht allein sichergestellt werden.

Für lange, mit viel Kupfer stabilisierte Drähte, wie sie beispielsweise in der Medizintechnik gefordert werden, ist es bekannt, im Rahmen der bereits erwähnten "Wire in Channel"(=WIC)-Technik einen Innendraht, der supraleitende Filamente enthält, mit einer Stabilisierungsstruktur aus Kupfer zu versehen. Die Stabilisierungsstruktur besteht hierbei aus einem Kupferdraht mit näherungsweise rechteckförmigem Querschnitt, welcher an einer der langen Seiten des rechteckförmigen Querschnitts eine Rille (auch Kehle genannt) zur Aufnahme des Innendrahts aufweist. Um einen guten elektrischen Kontakt und auch einen guten mechanischen Halt des Innendrahts sicherzustellen, werden der Innendraht und die Stabilisierungsstruktur durch ein Bad mit einem flüssigen, zinnhaltigen Lot geführt.

Mit "Wire in Channel" gefertigte Supraleiterdrähte können nur noch in engen Grenzen nachträglich verformt werden, was einige Anwendungen ausschließt, insbesondere solche, in denen runde Querschnitte von Supraleiterdrähten vorausgesetzt werden. Ebenso können Supraleiterdrähte mit großem Breite-zu Höhe-Verhältnis nicht aus einem WIC-Supraleiterdraht gewalzt werden.

Ein weiterer Nachteil der WIC-Technik ist das üblicherweise in dem zinnhaltigen Lot enthaltene Blei. Dieses ist für den Menschen (und auch viele andere Lebewesen) giftig und daher aus Umweltschutzgründen unerwünscht. Zwar sind bereits bleifreie Lote bekannt geworden; diese neigen jedoch zur sogenannten "Zinnpest", das ist eine Umwandlung von beta-Sn in alpha-Sn, die mit einer Volumenzunahme einhergeht und Lötnähte nach einiger Zeit zerfallen lässt.

Die GB 1,130,464 beschreibt ein Verfahren zur Herstellung eines supraleitenden Kabels, wobei ein indiumbeschichtetes Band zunächst zu einem U-förmigen Profil verformt wird, eine Anzahl von mit Indium überzogenen Supraleitern eingelegt wird, und sodann durch einen Bördelvorgang das Band geschlossen wird. Dabei kann insbesondere eine Überlappungsnaht ausgebildet werden, die in einem Abschnitt parallel zur Oberfläche des Bandes und in einem Abschnitt senkrecht zur Oberfläche des Bandes verläuft. Die Überlappungsnaht wird verschweißt.

### Aufgabe der Erfindung

Der Erfindung liegt die Aufgabe zugrunde, ein Verfahren zur Fertigung eines Supraleiterdrahts zur Verfügung zu stellen, durch das der Querschnitt des Supraleiterdrahts weniger limitiert wird, und welches die Verwendung bleifreier Lote gestattet, und bei dem die supraleitenden Filamente besser vor Beschädigung geschützt sind, insbesondere beim Schweißen der Nähte.

### Kurze Beschreibung der Erfindung

Diese Aufgabe wird gelöst durch ein Verfahren der eingangs genannten Art, das dadurch gekennzeichnet ist,
dass in dem kontinuierlichen oder quasi-kontinuierlichen Prozess das oder die mehreren Mantelelemente so ausgewählt und an den Innendraht angeformt und/oder angelegt werden, dass im Querschnitt alle Nähte von einander gegenüberliegenden Mantelelement-Enden schräg zur lokalen Innendraht-Oberfläche und schräg zur lokalen Mantelelement-Oberfläche verlaufen, und dass alle schräg zur lokalen Innendraht-Oberfläche und schräg zur lokalen Mantelelement-Oberfläche verlaufenden Nähte im Querschnitt jeweils wenigstens zweimal so lang sind wie die Dicke der Mantelelement-Enden senkrecht zur Oberfläche der Mantelelement-Enden.

Das oder die umhüllenden Mantelelemente bilden die Stabilisierungsstruktur für den Innendraht. Die Erfindung schlägt vor, den Innendraht vollständig (über den vollen Umfang des Innendrahts) mit dem oder den Mantelelementen zu umhüllen. Dadurch wird eine Kehle, wie sie bei der WIC-Technik in der Stabilisierungsstruktur auftritt, vermieden. Der Innendraht kann insbesondere zentriert in die Stabilisierungsstruktur eingebracht werden, was sehr große Freiheiten für eine nachträgliche Umformung (etwa ein Walzen) lässt; fertigungstechnische Schwachstellen, wie sie etwa im Bereich der freiliegenden Seite des Innendrahts im Rahmen von WIC auftreten, werden vermieden.

Die Kontaktflächen zwischen Innendraht und dem oder den Mantelelementen sind im Wesentlichen versiegelt, wodurch das Risiko für die Entstehung und Ausbreitung von Zinnpest bei Einsatz eines bleifreien, zinnhaltigen Lots an diesen Kontaktflächen minimiert ist. Die Zinnpest und Whiskerbildung geht in aller Regel von einer freien Oberfläche aus; im Rahmen der Erfindung sind die Kontaktflächen zwischen dem Innendraht und den Mantelelementen aber gerade nicht frei. Daher ist dieses Verfahren besonders für die Verwendung eines bleifreien, zinnhaltigen Lots an diesen Kontaktflächen geeignet. Grundsätzlich ist aber auch eine gegenseitige Kontaktierung ohne ein Lot denkbar.

Unabhängig von der Verwendung eines Lots können im Rahmen der Erfindung Innendraht-Außenseiten und Mantelelement-Innenseiten vor der gegenseitigen Kontaktierung gereinigt (insbesondere entfettet) und/oder mechanisch präpariert und/oder chemisch präpariert (insbesondere angeätzt, etwa in einem HCl-Bad) werden, um eine ausreichende elektrische und mechanische Verbindung für die dauerhafte Sicherstellung der Stabilisierungsfunktion herzustellen. Insbesondere wenn kein Lot verwendet wird, ist es vorteilhaft, wenn im Rahmen des kontinuierlichen oder quasi-kontinuierlichen Prozesses eine zumindest geringfügige oberflächennahe plastische Verformung des Innendrahts und/oder des oder der Mantelelemente stattfindet, so dass die sich gegenüberliegenden Oberflächenprofile näherungsweise übereinstimmen. In ähnlicher Weise können die einander gegenüberliegenden Mantelelement-Enden vor dem Verlöten und/oder Verschweißen gereinigt (insbesondere entfettet) und/oder mechanisch präpariert und /oder chemisch präpariert (insbesondere angeätzt, etwa in einem HCl-Bad) werden, um eine dauerhaft stabile Löt- oder Schweißnaht zu ermöglichen.

Die Stabilisierungsstruktur kann insbesondere näherungsweise kreisringförmig ausgebildet sein, was die nachträgliche Weiterverarbeitung des Supraleiterdrahts deutlich vereinfacht, da eine besondere Orientierung des Supraleiterdrahts dann in der Regel nicht mehr nötig ist.

Der Innendraht umfasst beispielsweise (und bevorzugt) NbTi-Filamente in einer Kupfermatrix. Es kommen aber auch andere Materialien, wie beispielsweise NbTa-Filamente und eine Bronze-Matrix, in Betracht.

Im Rahmen der Erfindung ist es möglich, lediglich ein Mantelelement an den Innendraht anzulegen und anzuformen; in diesem Fall ist eine gewisse plastische Verformung des Mantelelements bei angelegtem Innendraht erforderlich. Bei Verwendung nur eines Mantelelements gibt es nur eine Naht. Für die Anformung des Mantelelements können bekannte Techniken und Maschinen aus der Produktion von kupferummantelten Aluminium- oder Stahldrähten eingesetzt werden (CCA copper cladded aluminum; CCS copper cladded steel).

Ebenso ist es möglich, mehrere Mantelelemente (meist zwei) an den Draht anzulegen; in diesem Fall braucht keine plastische Verformung der Mantelelemente bei angelegtem Innendraht mehr zu erfolgen; eine plastische Verformung kann aber erfolgen, falls gewünscht. Bei Verwendung von zwei Mantelelementen gibt es zwei Nähte, bei noch mehr Mantelelementen entsprechend mehr.

Durch die nachträgliche Anbringung der Stabilisierungsstruktur an den Innendraht kann der Querschnittsanteil der Stabilisierungsstruktur relativ frei bzw. variabel gewählt werden (insbesondere über die Dicke des oder der anzuformenden oder anzulegenden Mantelelemente). Über die Menge (Dicke) des Mantelmaterials können entsprechend die mechanischen und elektrischen Eigenschaften des Supraleiterdrahts im normalleitenden Zustand eingestellt werden. Insbesondere kann dann auch ein hoher und für medizinische Anwendungen ausreichender Stabilisierungsgrad leicht eingestellt werden.

Im Rahmen der Erfindung ist vorgesehen, dass in dem kontinuierlichen oder quasi-kontinuierlichen Prozess das oder die mehreren Mantelelemente so ausgewählt und an den Innendraht angeformt und/oder angelegt werden, dass im Querschnitt alle Nähte von einander gegenüberliegenden Mantelelement-Enden schräg zur lokalen Innendraht-Oberfläche und schräg zur lokalen Mantelelement-Oberfläche verlaufen. Durch diesen Aufbau wird eine im Querschnitt längere Naht gewählt als es die lokale Dicke des oder der Mantelelemente (im Bereich der Naht) erfordern würden. Dadurch wird erreicht, dass ein Wärmeeintrag durch Schweißen am äußeren Ende der Naht über eine größere Länge und damit größeren Raum um die Naht herum verteilt wird. Die Wärme dringt vor allem entlang der Naht ins Innere des gerade gefertigten Supraleiterdrahts vor, insbesondere wenn die Naht mit einem zinnhaltigen Lot versehen ist. Eine Temperaturspitze kann die supraleitenden Eigenschaften der Filamente im Innendraht beinträchtigen ("Beschädigung"), so dass eine weitere Verteilung der Wärme zum Schutz der Filamente beiträgt. Für die Fertigung von schrägen Nähten werden typischerweise Mantelelemente mit im Querschnitt schrägen Seitenkanten eingesetzt. Die Naht kann beispielsweise tangential zur inneren und/oder äußeren Grenzfläche des oder der Mantelelemente verlaufen; ebenso ist ein hyperbolischer Verlauf möglich.

Weiterhin sind alle schräg zur lokalen Innendraht-Oberfläche und schräg zur lokalen Mantelelement-Oberfläche verlaufenden Nähte im Querschnitt jeweils wenigstens zweimal so lang sind wie die Dicke der Mantelelement-Enden senkrecht zur Oberfläche der Mantelelement-Enden. Dadurch hat sich in der Praxis ein guter Schutz der supraleitenden Filamente im Innendraht ergeben.

### Bevorzugte Varianten der Erfindung

Bei einer bevorzugten Variante ist vorgesehen, dass der Innendraht mit einem runden Querschnitt gewählt wird und das oder die mehreren Mantelelemente so ausgewählt und an den Innendraht angeformt und/oder angelegt werden, dass die Stabilisierungsstruktur einen runden Außenquerschnitt aufweist, und die Stabilisierungsstruktur im Querschnitt eine einheitliche Dicke aufweist.

Bevorzugt ist auch eine Variante, bei der am im Querschnitt äußeren Ende einer jeden Naht die Mantelelement-Enden miteinander verschweißt werden, insbesondere durch Laserschweißen. Durch Schweißen lassen sich besonders feste Nähte herstellen. Beim Laserschweißen ist der Wärmeeintrag im Vergleich zu anderen Schweißtechniken besonders gering, wodurch die supraleitenden Filamente, die durch Temperaturspitzen beschädigt werden können, geschützt werden.

Eine ganz besonders bevorzugte Verfahrensvariante sieht vor, dass in dem kontinuierlichen oder quasikontinuierlichen Prozess ein ungetwisteter Innendraht eingesetzt wird, so dass alle Nähte parallel zu den supraleitenden Filamenten des Innendrahts verlaufen,
und dass der Supraleiterdraht, nachdem der Innendraht mit der Stabilisierungsstruktur versehen worden ist, getwistet wird. Falls es beim Schweißen der Nähte im Rahmen der Anbringung der Stabilisierungsstruktur durch den Wärmeeintrag entlang der Naht zu einer Beschädigung einiger weniger schweißnahtnaher supraleitender Filamente im Innendraht kommen sollte, so werden während des gesamten Schweißprozesses immer dieselben supraleitenden Filamente beschädigt. Die übrigen Filamente des Innendrahtes bleiben unbeschädigt, so dass die Stromtragfähigkeit nur geringfügig vermindert wird.

Bevorzugt ist auch eine Verfahrensvariante, die vorsieht, dass im Rahmen des kontinuierlichen oder quasikontinuierlichen Prozesses ein festes, zinnhaltiges Lot zwischen das oder die Mantelelemente und den Innendraht eingebracht wird, insbesondere wobei das feste, zinnhaltige Lot bleifrei ist,
und dass nach dem Anformen und/oder Anlegen des oder der Mantelelemente an den Innendraht eine Wärmebehandlung erfolgt, durch die das zinnhaltige Lot aufgeschmolzen wird. Durch dieses Vorgehen ist ein Verlöten der Kontaktflächen von Innendraht und Mantelelement oder Mantelelementen im Inneren der Supraleiterdrahts möglich; insbesondere ist kein Durchlaufen eines Bads von flüssigem Lot notwendig. Freie Lotoberflächen, von denen eine Zinnpest ausgehen könnte, werden vermieden. Ein Eindringen von Zinnpest über die Naht ist nicht zu erwarten, da die Lotzusammensetzung im Bereich der Naht meist ohnehin von der Zusammensetzung weiter innen abweicht (etwa durch Legierungsprozesse mit den Mantelelementenden) und dadurch die Zinnpest aufgehalten wird; ggf. kann auch die Lotzusammensetzung im Bereich der Naht gezielt abweichend eingestellt werden, um ein Propagieren von Zinnpest durch die Naht zu verhindern (ggf. auch auf Kosten der elektrischen Leitfähigkeit, die im Bereich der Naht nicht so erheblich ist). Im einfachsten Fall sind die Mantelelementenden am äußeren Ende der Naht verschweißt, so dass die gelöteten Bereiche durch Mantelelementmaterial (meist Kupfer) versiegelt sind und allein dadurch ein Eindringen von Zinnpest verhindert wird.

Bei einer vorteilhaften Weiterentwicklung dieser Variante sind das eine oder die mehreren Mantelelemente, die in dem kontinuierlichen oder quasi-kontinuierlichen Prozess eingesetzt werden, an ihrer dem Innendraht zugewandten Seite mit einem zinnhaltigen Lot beschichtet worden. In diesem Fall beeinflusst das Einbringen des Lots das Anlegen bzw. Anformen des oder der Mantelelemente an den Innendraht nicht, so dass diese Abläufe besonders einfach gehalten werden können.

Bei einer anderen Weiterentwicklung zur oben genannten Verfahrensvariante wird vor oder beim Anformen und/oder Anlegen des oder der Mantelelemente an den Innendraht eine Folie aus einem zinnhaltigen Lot zwischen das oder die Mantelelemente und den Innendraht eingelegt. In diesem Fall brauchen das oder die Mantelelemente nicht vorab mit dem Lot beschichtet zu werden.

Bei einer anderen Verfahrensvariante ist vorgesehen, dass im Rahmen des kontinuierlichen oder quasikontinuierlichen Prozesses ein festes, zinnhaltiges Lot zwischen den Mantelelement-Enden eingebracht wird, insbesondere wobei das feste, zinnhaltige Lot bleifrei ist,
und dass nach dem Anformen und/oder Anlegen des oder der Mantelelemente an den Innendraht eine Wärmebehandlung erfolgt, durch die das zinnhaltige Lot aufgeschmolzen wird,
insbesondere wobei das eine oder die mehreren Mantelelemente, die in dem kontinuierlichen oder quasi-kontinuierlichen Prozess eingesetzt werden, zumindest an einem Teil ihrer Mantelelement-Enden mit einem zinnhaltigen Lot beschichtet worden sind, und/oder wobei vor oder beim Anformen und/oder Anlegen des oder der Mantelelemente an den Innendraht eine Folie aus einem zinnhaltigen Lot zwischen die Mantelelement-Enden eingelegt wird. Durch dieses Vorgehen ist ein Verlöten der gegenüberliegenden Mantelelementenden möglich, ohne dass ein Durchlaufen eines Bads von flüssigem Lot notwendig ist. Freie Lotoberflächen, von denen eine Zinnpest ausgehen könnte, werden vermieden. Ein Eindringen von Zinnpest über die Naht ist nicht zu erwarten, da die Lotzusammensetzung im Bereich der Naht meist ohnehin von zinnpestanfälligen Zusammensetzungen abweicht (etwa durch Legierungsprozesse mit den Mantelelementenden); ggf. kann auch die Lotzusammensetzung im Bereich der Naht gezielt abweichend eingestellt werden, um ein Propagieren von Zinnpest durch die Naht zu verhindern (ggf. auch auf Kosten der elektrischen Leitfähigkeit, die im Bereich der Naht nicht so erheblich ist). Im einfachsten Fall sind die Mantelelementenden am äußeren Ende der Naht verschweißt, so dass die gelöteten Bereiche durch Mantelelementmaterial (meist Kupfer) versiegelt sind und allein dadurch ein Eindringen von Zinnpest verhindert wird.

Besonders bevorzugt ist eine Variante, die vorsieht, dass in dem kontinuierlichen oder quasi-kontinuierlichen Prozess lediglich ein Mantelelement eingesetzt wird, und dass das Mantelelement um den Innendraht herum geformt wird. Diese Variante wird vor allem für dünne Stabilisierungsstrukturen eingesetzt, bei denen eine plastische Verformung gut und leicht möglich ist. Meist werden ebene oder U-förmig vorgeformte Mantelelemente eingesetzt. Es brauchen weiterhin nur zwei Güter (Innendraht und ein Mantelelement) verarbeitet zu werden.

Ebenfalls bevorzugt ist eine Verfahrensvariante, die vorsieht, dass in dem kontinuierlichen oder quasi-kontinuierlichen Prozess zwei als Halbschalen vorgeformte Mantelelemente eingesetzt werden,
und dass die Halbschalen an den Innendraht angelegt werden. Bei dieser Variante braucht keine plastische Verformung der Mantelelemente vorgenommen zu werden, was die Verfahrensführung diesbezüglich einfach macht. In der Regel wird in dieser Variante ein Lot im Inneren des Supraleiterdrahts eingesetzt (siehe oben). Die Halbschalen können beispielsweise einen kreisrunden Außenquerschnitt aufweisen, oder auch einen näherungsweise halbquaderförmigen Außenquerschnitt aufweisen. Der Innenquerschnitt der Halbschalen ist dem (meist kreisrunden) Außenquerschnitt des Innendrahts angepasst.

Vorteilhaft ist eine Verfahrensvariante, bei der der Supraleiterdraht einem Umform- oder Ziehprozess unterzogen wird, nachdem der Innendraht mit der Stabilisierungsstruktur versehen worden ist. Dadurch kann der Supraleiterdraht an eine bestimmten Anwendung angepasst werden, ohne dass der Ummantelungsprozess abgeändert zu werden braucht.

Eine vorteilhafte Weiterentwicklung dieser Variante sieht vor, dass durch den Umform- oder Ziehprozess ein näherungsweise rechteckiger oder näherungsweiser runder Querschnitt des Supraleiterdrahts eingestellt wird. Drähte mit rechteckigem Querschnitt können Kräfte senkrecht zu ihren flachen Außenkanten besser aufnehmen. Ein runder Außenquerschnitt erlaubt eine einfache nachfolgende Handhabung , bei der nur wenig oder gar nicht auf die Drehorientierung des Drahtes geachtet werden muss.

Bevorzugt ist auch ein Verfahren, bei dem der Supraleiterdraht mit einem elektrisch isolierenden Lack beschichtet wird, nachdem der Innendraht mit der Stabilisierungsstruktur versehen worden ist. Mit dem erfindungsgemäßen Verfahren können für eine Lackierung gut geeignete Außenquerschnitte eingestellt werden, beispielsweise mit allseitig relativ großen Krümmungsradien, die eine gute Benetzung und geringen Abrieb ermöglichen, bis hin zu einem kreisrunden Außenquerschnitt des Supraleiterdrahts.

Bei einer bevorzugten Verfahrensvariante sind das oder die Mantelelemente aus Kupfer, Stahl, Aluminium oder Legierungen von Kupfer, Eisen und/oder Aluminium gefertigt. Diese Materialien bzw. Elemente haben sich für die Stabilisierungsfunktion in mechanischer, elektrischer und/oder thermischer Hinsicht besonders bewährt.

In den Rahmen der vorliegenden Erfindung fällt auch ein Supraleiterdraht, umfassend einen Innendraht, der supraleitende Filamente enthält, und eine normalleitende Stabilisierungsstruktur,
wobei die Stabilisierungsstruktur den Innendraht über seinen gesamten Umfang umhüllt, wobei die Stabilisierungsstruktur ein oder mehrere Mantelelemente umfasst,
wobei der Supraleiterdraht eine oder mehrere, sich über die gesamte Länge des Supraleiterdrahts erstreckende Nähte von einander gegenüberliegenden Mantelelement-Enden aufweist,
und wobei alle Nähte von einander gegenüberliegenden Mantelelement-Enden verlötet und/oder verschweißt sind,
dadurch gekennzeichnet, dass im Querschnitt alle Nähte von einander gegenüberliegenden Mantelelement-Enden schräg zur lokalen Innendraht-Oberfläche und schräg zur lokalen Mantelelement-Oberfläche verlaufen,
und dass alle schräg zur lokalen Innendraht-Oberfläche und schräg zur lokalen Mantelelement-Oberfläche verlaufenden Nähte im Querschnitt jeweils wenigstens zweimal so lang sind wie die Dicke der Mantelelement-Enden senkrecht zur Oberfläche der Mantelelement-Enden, insbesondere wobei der Supraleiterdraht gefertigt ist nach einem obigen, erfindungsgemäßen Verfahren. Ein solcher Draht kann unabhängig von den Begrenzungen bei der Fertigung des Innendrahts mit einer Stabilisierungsstruktur versehen werden, die verschiedenste, noch nachfolgende Umformprozesse gestattet; der Supraleiterdraht ist dadurch besonders breit einsetzbar und flexibel anpassbar. Ebenso ist er gut für die Verwendung bleifreier Lote geeignet, da üblicherweise gelötete Bereiche im Wesentlichen durch das oder die Mantelelemente abgedeckt werden. Dadurch, dass im Querschnitt alle Nähte von einander gegenüberliegenden Mantelelement-Enden schräg zur lokalen Innendraht-Oberfläche und schräg zur lokalen Mantelelement-Oberfläche verlaufen, wird ein Wärmeeintrag durch Schweißen am äußeren Ende der Naht weiter verteilt und so eine Beschädigung von Supraleiterfilamenten im Innendraht vermieden.

Bevorzugt ist eine Ausführungsform, die vorsieht, dass der Innendraht einen runden Querschnitt aufweist und die Stabilisierungsstruktur einen runden Außenquerschnitt aufweist, und die Stabilisierungsstruktur im Querschnitt eine einheitliche Dicke aufweist.

Besonders bevorzugt ist eine Ausführungsform, bei der am im Querschnitt äußeren Ende einer jeden Naht die Mantelelement-Enden miteinander verschweißt sind. Dadurch ist die Naht zum einen besonders stabil und zum anderen wird das Innere des Supraleiterdrahts dauerhaft versiegelt, so dass beispielsweise Luftsauerstoff nicht mehr eindringen kann. Im Inneren vorhandenes, bleifreies zinnhaltiges Lot wird zuverlässig vor der Zinnpest geschützt.

Bei einer vorteilhaften Ausführungsform ist zwischen dem Innendraht und dem oder den Mantelelementen und/oder zwischen den einander gegenüberliegenden Mantelelement-Enden ein zinnhaltiges Lot, insbesondere ein bleifreies zinnhaltiges Lot, angeordnet. Das Lot verbessert den mechanischen und vor allem den elektrischen Kontakt zwischen dem Innendraht und der Stabilisierungsstruktur bzw. an den Nähten. Das bleifreie Lot ist besonders umweltfreundlich; aufgrund des Aufbaus des Supraleiterdrahts kann dieses vor Zinnpest gut geschützt werden.

Schließlich ist auch noch eine Ausführungsform bevorzugt, bei der die Stabilisierungsstruktur zwei Mantelelemente umfasst, die über zwei Nähte miteinander verlötet und/oder verschweißt sind. In diesem Fall kann der Querschnitt des Supraleiterdrahts besonders einfach flexibel gewählt werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine schematische Seitenansicht einer Bearbeitungslinie, an der ein Supraleiterdraht gefertigt wird, wobei ein Mantelelement an einen Innendraht angeformt wird, zur allgemeinen Erläuterung;
- Fig. 2: verschiedene Querschnitte des Innendrahts und des Mantelelements von Fig. 1 im Laufe des Anformungsprozesses, zur allgemeinen Erläuterung;
- Fig. 3: eine schematische Seitenansicht einer Bearbeitungslinie, an der ein Supraleiterdraht gefertigt wird, wobei zwei halbschalenförmige Mantelelemente an einen Innendraht angelegt werden, zur allgemeinen Erläuterung;
- Fig. 4: verschiedene Querschnitte des Innendrahts und der Mantelelemente von Fig. 3 im Laufe des Anlegeprozesses, zur allgemeinen Erläuterung;
- Fig. 5a-5d: verschiedene Querschnitte von Supraleiterdrähten, zur allgemeinen Erläuterung;
- Fig. 6: eine schematische Übersicht zur Fertigung eines Supraleiterdrahts, mit an der langen und einer kurzen Seite verzinntem Mantelelement, zur allgemeinen Erläuterung;
- Fig. 7: eine schematische Übersicht zur Fertigung eines Supraleiterdrahts, mit eingelegter Zinnfolie, die die lange Seite des Mantelelements beidseitig überlappt, zur allgemeinen Erläuterung;
- Fig. 8: eine schematische Übersicht zur Fertigung eines Supraleiterdrahts, mit nur an der langen Seite verzinntem Mantelelement, zur allgemeinen Erläuterung;
- Fig. 9: eine schematische Übersicht zur Fertigung eines Supraleiterdrahts, mit zwischen den Mantelelement-Enden eingelegter Zinnfolie, zur allgemeinen Erläuterung;
- Fig. 10: eine schematische Übersicht zur Fertigung eines Supraleiterdrahts im Rahmen der Erfindung, mit schräg verlaufender Naht;
- Fig. 11: eine schematische Übersicht zur Fertigung eines Supraleiterdrahts im Rahmen der Erfindung, mit zwei halbschalenförmigen Mantelelementen, mit schräg verlaufenden Nähten;
- Fig. 12: eine Schemadarstellung zum nachträglichen Twisten eines Supraleiterdrahts, zur allgemeinen Erläuterung;
- Fig. 13: eine Schemadarstellung zum nachträglichen Umformen des Querschnitts eines Supraleiterdrahts, zur allgemeinen Erläuterung;
- Fig. 14: eine Schemadarstellung zum nachträglichen Lackieren eines Supraleiterdrahts, zur allgemeinen Erläuterung.

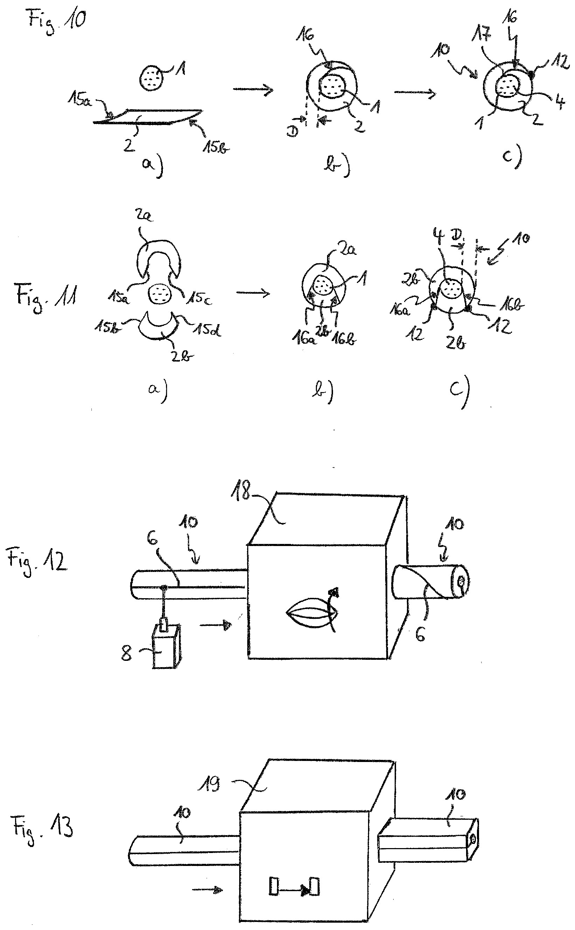

Die vorliegende Erfindung betrifft ein Verfahren zur Fertigung eines Supraieiterdrahts mit einer schrägen Naht und weiterhin einen Supraleiterdraht mit einer schrägen Naht, wie in Anspruch 1 und Anspruch 15 beschrieben. Entsprechende Verfahren und Supraleiterdrähte sind in Fig. 10 und 11 erläutert; die übrigen Figuren zeigen allgemeine Prinzipien bei der Fertigung eines Supraleiterdrahts ohne schräge Naht, die aber analog bei einem erfindungsgemäßen Verfahren bzw. einem erfindungsgemäßen Supraleiterdraht angewandt werden können.

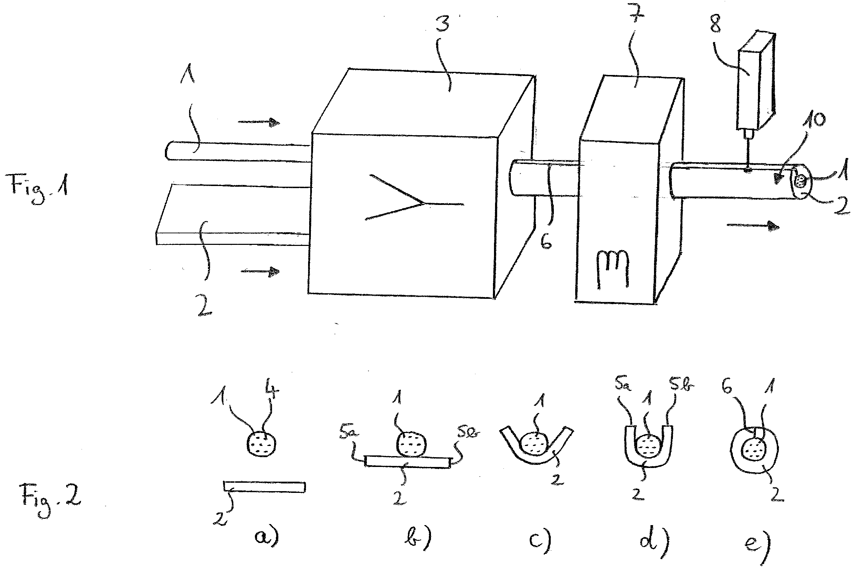

Die **Figur 1** illustriert in einer Schemadarstellung die Fertigung eines Supraleiterdrahts in einer ersten allgemeinen Variante.

Ein hier runder Innendraht 1, der supraleitende Filamente (beispielsweise aus NbTi) enthält, und ein hier vor der Vorformung eben ausgebildetes Mantelelement 2 (beispielsweise aus Kupfer) werden kontinuierlich in ein Formwerkzeug 3 eingeführt bzw. durch dieses gezogen, wobei das Mantelelement 2 plastisch verformt wird.

Das Mantelelement 2 wird dabei zunächst an den Innenleiter 1 herangeführt und dann auch um den Innenleiter 1 herum gehüllt, vgl. dazu die **Figur 2 a)** **bis e)**, die den zeitlichen Ablauf des Prozesses im Formwerkzeug 3 in Querschnittsdarstellungen näher erläutert. In den Querschnittsdarstellungen sind auch die supraleitenden Filamente 4 im Innendraht 1 angedeutet. Durch die plastische Umformung werden die beiden Mantelelement-Enden 5a, 5b schließlich in eine einander gegenüberliegende Position gebracht, in der sie typischerweise aneinanderstoßen, gegebenenfalls auch über Zwischenmaterialien wie ein Lot, und der Innendraht 1 praktisch vollständig vom Mantelelement 2 umhüllt ist. Die sich gegenüberliegenden Mantelelement-Enden 5a, 5b bilden eine Naht 6 aus.

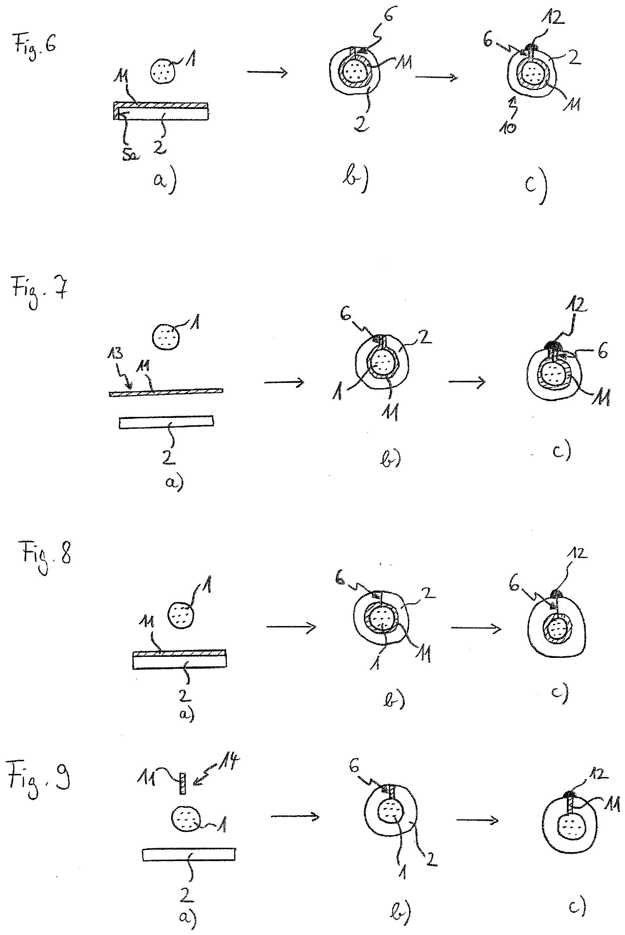

Zur mechanischen Stabilisierung erfolgt typischerweise anschließend eine Erwärmung, etwa in einem elektrischen Ofen 7, um ein Lot aufzuschmelzen, das zwischen dem Innendraht 1 und dem umhüllenden Mantelelement 2 oder auch in der Naht 6 angeordnet ist (zur Einbringung des Lots siehe insbesondere Figuren 6 bis 9). Alternativ oder (bevorzugt) zusätzlich wird die Naht 6 verschweißt, hier mit einem Laserschweißgerät 8. Falls gewünscht oder erforderlich kann zwischen dem Ofen 7 und dem Laserschweißgerät 8 eine Kühlstufe vorgesehen sein. Die geschweißte Naht 6 versiegelt das Innere des fertigen Supraleiterdrahts 10, so dass dieses vor unerwünschten Umwelteinflüssen geschützt ist.

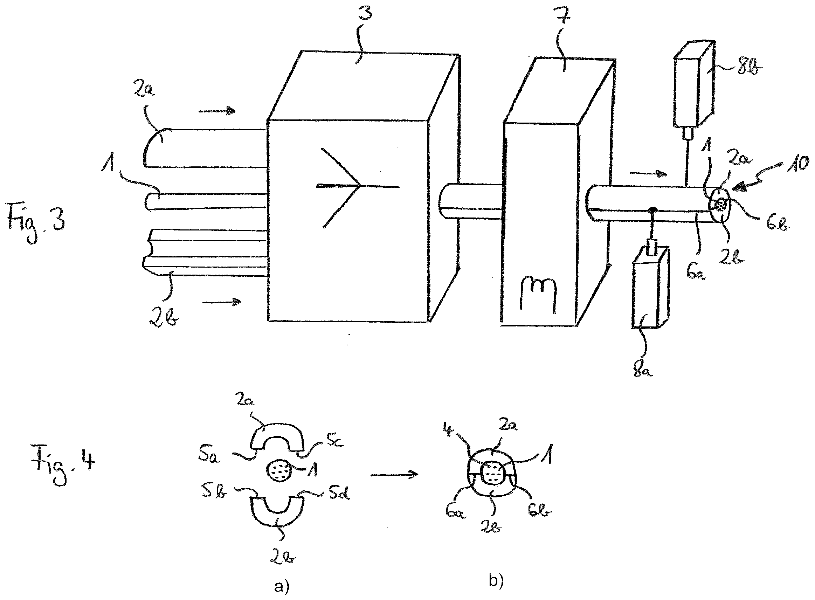

Eine alternative allgemeine Variante zur Fertigung eines Supraleiterdrahts im ist in **Figur 3** dargestellt.

Das Formwerkzeug 3 wird hier mit dem Innendraht 1 und zwei als Halbschalen vorgeformte Mantelelementen 2a, 2b kontinuierlich beschickt.

Im Formwerkzeug 3 werden die Mantelelemente 2a, 2b und der Innendraht 1 zusammengeführt, wie in der **Figur 4 a)** **und b)** ersichtlich ist, die wiederum den zeitlichen Ablauf des Prozesses im Formwerkzeug 3 in Querschnittsdarstellungen näher erläutert. Falls gewünscht, kann dabei auch eine (typischerweise geringe) plastische Verformung der Mantelelemente 2a, 2b erfolgen. Die halbschalenförmigen Mantelelemente 2a, 2b umschließen schließlich praktisch vollständig den Innendraht 1, wobei die Mantelelement-Enden 5a, 5b, 5c, 5d in einander gegenüberliegender Position zwei Nähte 6a, 6b ausbilden. Typischerweise berühren sich die gegenüberliegenden Mantelelementen-Enden 5a, 5b bzw. 5c, 5d, gegebenenfalls auch über Zwischenmaterialien wie ein Lot.

Zur mechanischen Stabilisierung erfolgt typischerweise anschließend wiederum eine Erwärmung, etwa in einem elektrischen Ofen 7, um ein Lot aufzuschmelzen, das zwischen dem Innendraht 1 und den umhüllenden Mantelelementen 2a, 2b oder auch in den Nähten 6a, 6b angeordnet ist (zur Einbringung des Lots siehe insbesondere Figuren 6 bis 9). Alternativ oder (bevorzugt) zusätzlich werden die Nähte 6a, 6b verschweißt, hier mit zwei Laserschweißgeräten 8a, 8b. Falls gewünscht oder erforderlich kann zwischen dem Ofen 7 und dem ersten Laserschweißgerät 8a eine Kühlstufe vorgesehen sein. Die geschweißten Nähte 6a, 6b versiegeln das Innere des fertigen Supraleiterdrahts 10, so dass dieses vor unerwünschten Umwelteinflüssen geschützt ist.

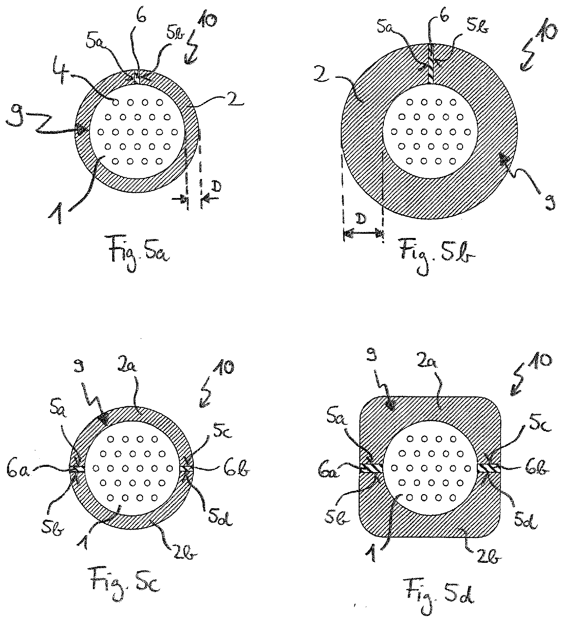

In den **Figuren 5a bis 5d** werden verschiedene allgemeine Bauformen von Supraleiterdrähten 10 im Querschnitt erläutert.

In allen vier Fällen ist ein gleich großer, runder Innendraht 1 mit hier 24 supraleitenden Filamenten 4 zentral im Supraleiterdraht 10 angeordnet. Der Innendraht 1 ist jeweils über praktisch den gesamten Umfang von einer Stabilisierungsstruktur 9, etwa aus elementarem Kupfer, umgeben.

Die Stabilisierungsstruktur 9 umfasst in den Ausführungsformen von Fig. 5a und 5b jeweils nur ein Mantelelement 2, wobei die einander gegenüberliegenden Enden 5a, 5b eine Naht 6 ausbilden. Je nach gewünschter Anwendung für den Supraleiterdraht 10 kann die Dicke D des Mantelelements 2 geeignet gewählt werden, um den gewünschten Grad der Stabilisierung einzustellen bzw. ein gewünschtes Gewicht pro Länge zu erhalten oder dergleichen mehr.

Die Stabilisierungsstruktur 9 kann aber auch durch zwei halbschalenartige Mantelelemente 2a, 2b ausgebildet werden, wie in den Ausführungsformen von Fig. 5c und 5d gezeigt; es ist sogar möglich, drei oder noch mehr Mantelelemente einzusetzen. Die gegenüberliegenden Enden 5a, 5b, 5c, 5d bilden wiederum Nähte 6a, 6b aus. Durch Wahl geeigneter Querschnittsformen, einschließlich absoluter Abmessungen, der Mantelelemente 2a, 2b kann wiederum eine Anpassung an eine gewünschte Anwendung für den Supraleiterdraht 10 erfolgen. Insbesondere können neben runden Außenquerschnitten, vgl. Fig. 5c, auch rechteckige oder näherungsweise rechteckige Querschnittsformen, vgl. Fig. 5d, gewählt werden. Die Auswahl ist hierbei grundsätzlich nicht durch plastische Verformungsprozesse im Rahmen des Umhüllungsprozesses (vgl. Fig. 1 bis 4) eingeschränkt, da die halbschalenförmigen Mantelelemente 2a, 2b ohne plastische Verformung angelegt werden können.

Die Figuren 6 bis 9 illustrieren verschiede Möglichkeiten, ein Lot, insbesondere ein bleifreies, zinnhaltiges Lot in den Herstellungsprozess einzubringen. Mit einem Lot (das üblicherweise auf Zinn basiert, aber grundsätzlich auch zinnfrei denkbar ist) kann die mechanische Festigkeit und der elektrische Kontakt im Inneren des Supraleiterdrahts verbessert werden, insbesondere zwischen der Stabilisierungsstruktur und dem Innendraht, aber auch zwischen den Mantelelement-Enden. Der Einfachheit halber ist in den Figuren jeweils eine allgemeine Variante mit nur einem Mantelelement dargestellt, ebenso können aber auch alle gezeigten Varianten bei mehreren Mantelelementen entsprechend eingesetzt werden. Dargestellt sind jeweils die Herstellung eines Supraleiterdrahts von den unverbundenen Ausgangsteilen a) über das Zusammenfügen b) bis zum fertigen, verschweißten Supraleiterdraht c).

In der allgemeinen Variante der **Figur 6** soll ein Lot 11 sowohl um den Innendraht 1 als auch in die Naht 6 eingebracht werden. Dafür wird das Mantelelement 2 sowohl an der (dem Innendraht 1 zugewandten) langen Seite als auch auf einer kurzen Seite, also an einem Mantelelement-Ende 5a, mit (festem) Lot 11 vorab beschichtet. Dabei erfolgt eine gezielte, lokale Auftragung des Lots 11, etwa mit einem Pinsel oder dergleichen, und zu Beginn des Zusammenfügeprozesses dargestellt bei a) ist das Lot 11 fest (bzw. trocken). Beim Zusammenfügen b) von Innendraht 1 und Mantelteil 2 ist das Lot 11 dann automatisch korrekt platziert, und insbesondere gibt es kein Lot an unerwünschten Stellen, etwa großflächig auf der Außenseite des Mantelelements 2, wie es durch ein Tauchbad praktisch unvermeidlich wäre. Durch das abschließende Schweißen c) am oberen Ende der Naht 6 wird die äußere (hier obere) Kante des Lots 11 versiegelt, vgl. den Schweißwulst 12, so dass diese nicht als Ausgangspunkt für die Zinnpest in Betracht kommt.

In der allgemeinen Variante von **Figur 7** wird eine Folie 13 aus Lot 11 zwischen das Mantelelement 2 und den Innendraht 1 eingelegt. Durch einen seitlichen Überstand der Folie 13 gegenüber dem Mantelelement 2, vgl. a), wird auch Lot 11 nicht nur um den Innendraht 1 herum, sondern auch in die Naht 6 eingebracht. Der Überstand ist hier beidseitig, so dass zwei Foliendicken von Lot 11 in der Naht 6 angeordnet sind, vgl. b); ein einseitiger Überstand würde für eine einfache Foliendicke Lot 11 in der Naht 6 genügen. Durch Verschweißen kann wiederum die obere Kante des Lots 11 in der Naht 6 versiegelt werden, vgl. den Schweißwulst 12 in c). Durch Einsatz der Folie 13 kann eine vorab-Beschichtung des Mantelelements 2 vermieden werden.

Falls nur ein Lot 11 um den Innendraht 1 herum gewünscht ist, kann die Beschichtung des Mantelelements 2 auf die dem Innendraht 1 zugewandte lange Seite des Mantelelements 2 beschränkt werden, wie aus **Figur 8**, insbesondere a), ersichtlich. In diesem Fall bleibt die Naht 6 nach dem Zusammenfügen lotfrei, siehe b). Eine Versiegelung der Naht 6 durch Verschweißen ist dann in der Regel nicht nötig, um eine Zinnpest zu verhindern, und kann daher entfallen. Dennoch kann ein Verschweißen der Naht 6 vorgenommen werden, um die mechanische Stabilität zu verbessern und zusätzliche Sicherheit vor der Zinnpest zu erlangen, vgl. c).

Im Einzelfall kann es auch erwünscht sein, nur die Naht 6 zu verlöten. Dazu kann beispielsweise ein kurzes Stück Folie 14 aus Lot 11 lediglich in die Naht 6 eingefügt werden, vgl. **Figur 9**, insbesondere a). Um den Innendraht 1 herum ist dann nach dem Zusammenfügen kein Lot angeordnet, vgl. b). In diesem Fall ist aber ein Verschweißen empfehlenswert, um mit dem Schweißwulst 12 die obere Kante des Lots 11 zu versiegeln.

Man beachte, dass der Schweißwulst 12 in der Praxis nicht notwendigerweise merklich über die Stabilisierungsstruktur bzw. das Mantelelement 2 hervorzusteht; er ist in den Figuren 6 bis 9 zum besseren Verständnis übertrieben worden. Der Schweißwulst ist typischerweise in die Naht hinein versenkt bzw. in diese integriert. Die Zusammensetzung des Schweißwulst entspricht näherungsweise der Zusammensetzung des angrenzenden Mantelelements 2, wobei jedoch Zusätze (etwa zur Absenkung der Schmelztemperatur) eingesetzt werden können, und auch Verunreinigungen durch benachbartes Material auftreten können.

In **Figur 10** wird in Querschnittsdarstellungen der Ablauf bei der Herstellung eines Supraleiterdrahtes 10 gemäß der Erfindung illustriert, wobei ein Mantelelement 2 mit Mantelelement-Enden 15a, 15b eingesetzt wird, die schräg zu den langen Seiten (bzw. zu zumindest den angrenzenden Teilen der langen Seiten) des Mantelelements 2 verlaufen, vgl. a). Entsprechend ergibt sich nach dem Zusammenfügen, dargestellt in b), sowohl gegenüber der lokalen (an die Naht angrenzenden) Teile der Außenkante des Innendrahts 1 als auch gegenüber der lokalen (an die Naht angrenzenden) Teile der Außenkante des Mantelelements 2 ein schräger (nicht-senkrechter) Verlauf der Naht 16. Im gezeigten Ausführungsbeispiel ist die Naht 16 zusätzlich noch leicht in sich gekrümmt.

Durch den schrägen Verlauf ist die Naht 16 deutlich länger (hier etwa zweimal länger) als für ein Umschließen des Innendrahts 1 nötig. Die kürzest möglich Naht (mit Verlauf senkrecht zur Außenkante des Mantelelements 2; "radialer Verlauf" oder "senkrechter Verlauf") hätte eine Länge entsprechend der Dicke D des Mantelelements 2; die Naht 16 hat eine Länge von ca. 2 x D.

Dadurch wird ein Wärmeeintrag durch Schweißen am äußeren Ende der Naht 16, vgl. den Schweißwulst 12 in c), über eine relativ lange Strecke verteilt, denn die eingetragene Wärme propagiert nach der Erfahrung der Erfinder am schnellsten entlang der Naht 16 (insbesondere wenn diese ein Lot enthält), jedoch weniger schnell durch das Mantelelement 2. Entsprechend ist die am inneren Ende 17 der Naht 16 erreichte Spitzentemperatur deutlich geringer als bei einer kürzeren Naht. Supraleitende Filamente 4, die durch hohe Temperaturen leicht degradiert werden können, sind dadurch besser vor thermischen Beschädigungen während der Herstellung des Supraleiterdrahts 10 geschützt.

Schräge Mantelelement-Endbereiche 15a, 15b, 15c, 15d können auch mit zwei Mantelelementen 2a, 2b eingesetzt werden, vgl. die Querschnittsdarstellungen von **Fig. 11****.** Entsprechend ergeben sich schräg verlaufende Nähte 16a, 16b, die wiederum deutlich länger sind als die kürzest möglichen Nähte, die senkrecht zu den lokalen Außenkanten (Oberflächen) des Innendrahts 1 und der Mantelelemente 2 verlaufen würden, vgl. nach dem Zusammenbau unter b). Dadurch wird wiederum die eingetragene Wärme, ausgehend von den äußeren Enden der Nähte 16a, 16b, siehe Schweißwulste 12, besser im Supraleiterddraht 10 verteilt. Man beachte, dass die äußeren Enden der Nähte 16a, 16b in Umfangsrichtung deutlich beabstandet sein sollten, so dass es zu keiner merklichen oder gar schädlichen Addition der Wärmeeinträge im Bereich der supraleitenden Filamente 4 kommt. Eine ausreichende Beabstandung ist meist gegeben, wenn der Abstand wenigstens doppelst so groß ist wie die Dicke D der Mantelelemente 2a, 2b

Im Rahmen der Erfindung können im Anschluss an Zusammenbau und Verlötung und/oder Verschweißung der Nähte eines Supraleiterdrahtes weitere Maßnahmen ergriffen werden, die in den Figuren 12 bis 14 vorgestellt werden.

Besonders vorteilhaft ist es, im Rahmen der Erfindung einen ungetwisteten (nicht in sich verdrillten) Innendraht zu verbauen, so dass bis einschließlich eines Schweißens der Naht oder der Nähte die supraleitenden Filamente parallel zu der Naht oder den Nähten verlaufen. Sollte durch das Schweißen doch ein kleiner Teil der supraleitenden Filamente in der Nähe des inneren Endes eine Naht beschädigt worden sein, so handelt es sich dabei über die gesamte Länge des Innendrahts stets um die gleichen Filamente, was meist nur einen geringen Verlust der supraleitenden Stromtragfähigkeit zur Folge hat. Um von den Vorteilen des Twistens (insbesondere einer Entkopplung der Filamente) dann noch profitieren zu können, sollte der Supraleiterdraht nach dem Schweißen noch getwistet werden, vgl. in **Figur 12** die schematisch dargestellte Twisteinheit 18 hinter dem Schweißgerät 8. Der resultierende Supraleiterdraht 10 weist nach dem Twisten eine oder mehrere spiralförmig gewundene Nähte 6 auf.

Ebenfalls ist es möglich, einen Supraleiterdraht nachträglich einem Umformprozess zu unterziehen, vgl. **Fig. 13****.** Dabei kann beispielsweise einem runden Supraleiterdraht 10 in einer Umformeinheit 19 ein flächengleicher oder flächenkleinerer, rechteckiger Außenquerschnitt aufgeprägt werden.

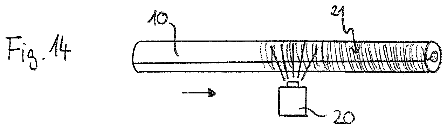

Schließlich kann ein Supraleiterdraht 10 auch noch nachträglich mit einem Lack 21, etwa einem elektrisch isolierenden Lack verssehen werden, wofür der Supraleiterdraht 10 kontinuierlich durch eine Lackiereinheit 20 verfahren werden kann, wie in **Fig. 14** dargestellt.

## Patentansprüche

1. Verfahren zur Fertigung eines Supraleiterdrahts (10),
wobei ein Innendraht (1), der supraleitende Filamente (4) enthält, mit einer normalleitenden Stabilisierungsstruktur (9) versehen wird,
wobei in einem kontinuierlichen oder quasi-kontinuierlichen Prozess ein oder mehrere Mantelelemente (2; 2a, 2b) an den Innendraht (9) angeformt und/oder angelegt werden, so dass der Innendraht (1) über seinen gesamten Umfang von dem einen oder den mehreren Mantelelementen (2; 2a, 2b) umhüllt wird, und wobei alle Nähte (16; 16a, 16b) von einander gegenüberliegenden Mantelelement-Enden (15a-15d) verlötet und/oder verschweißt werden,
**dadurch gekennzeichnet,**
**dass** in dem kontinuierlichen oder quasi-kontinuierlichen Prozess das oder die mehreren Mantelelemente (2; 2a, 2b) so ausgewählt und an den Innendraht (1) angeformt und/oder angelegt werden, dass im Querschnitt alle Nähte (16; 16a, 16b) von einander gegenüberliegenden Mantelelement-Enden (15a-15d) schräg zur lokalen Innendraht-Oberfläche und schräg zur lokalen Mantelelement-Oberfläche verlaufen, und dass alle schräg zur lokalen Innendraht-Oberfläche und schräg zur lokalen Mantelelement-Oberfläche verlaufenden Nähte (16; 16a, 16b) im Querschnitt jeweils wenigstens zweimal so lang sind wie die Dicke (D) der Mantelelement-Enden (15a-15d) senkrecht zur Oberfläche der Mantelelement-Enden (15a-15d).

2. Verfahren nach Anspruch 1, **dadurch gekennzeichnet, dass** der Innendraht (1) mit einem runden Querschnitt gewählt wird und das oder die mehreren Mantelelemente (2; 2a, 2b) so ausgewählt und an den Innendraht (1) angeformt und/oder angelegt werden, dass die Stabilisierungsstruktur (9) einen runden Außenquerschnitt aufweist, und die Stabilisierungsstruktur (9) im Querschnitt eine einheitliche Dicke (D) aufweist.

3. Verfahren nach einem der vorhergehenden Ansprüche, **dadurch gekennzeichnet, dass** am im Querschnitt äußeren Ende einer jeden Naht (6; 6a, 6b; 16; 16a, 16b) die Mantelelement-Enden (5a-5d; 15a-15d) miteinander verschweißt werden, insbesondere durch Laserschweißen.

4. Verfahren nach einem der vorhergehenden Ansprüche, **dadurch gekennzeichnet, dass** in dem kontinuierlichen oder quasikontinuierlichen Prozess ein ungetwisteter Innendraht (1) eingesetzt wird, so dass alle Nähte (6; 6a, 6b; 16; 16a, 16b) parallel zu den supraleitenden Filamenten (4) des Innendrahts (1) verlaufen,
und dass der Supraleiterdraht (10), nachdem der Innendraht (1) mit der Stabilisierungsstruktur (9) versehen worden ist, getwistet wird.

5. Verfahren nach einem der vorhergehenden Ansprüche, **dadurch gekennzeichnet,**
**dass** im Rahmen des kontinuierlichen oder quasikontinuierlichen Prozesses ein festes, zinnhaltiges Lot (11) zwischen das oder die Mantelelemente (2; 2a, 2b) und den Innendraht (1) eingebracht wird, insbesondere wobei das feste, zinnhaltige Lot (11) bleifrei ist,
und **dass** nach dem Anformen und/oder Anlegen des oder der Mantelelemente (2; 2a, 2b) an den Innendraht (1) eine Wärmebehandlung erfolgt, durch die das zinnhaltige Lot (11) aufgeschmolzen wird,.

6. Verfahren nach Anspruch 5, **dadurch gekennzeichnet, dass** das eine oder die mehreren Mantelelemente (2; 2a, 2b), die in dem kontinuierlichen oder quasi-kontinuierlichen Prozess eingesetzt werden, an ihrer dem Innendraht (1) zugewandten Seite mit einem zinnhaltigen Lot (11) beschichtet worden sind.

7. Verfahren nach einem der Ansprüche 5 oder 6, **dadurch gekennzeichnet, dass** vor oder beim Anformen und/oder Anlegen des oder der Mantelelemente (2; 2a, 2b) an den Innendraht (9) eine Folie (13) aus einem zinnhaltigen Lot (11) zwischen das oder die Mantelelemente (2; 2a, 2b) und den Innendraht (1) eingelegt wird.

8. Verfahren nach einem der vorhergehenden Ansprüche, **dadurch gekennzeichnet, dass** im Rahmen des kontinuierlichen oder quasikontinuierlichen Prozesses ein festes, zinnhaltiges Lot (11) zwischen den Mantelelement-Enden (5a-5d; 15a-15d) eingebracht wird, insbesondere wobei das feste, zinnhaltige Lot (11) bleifrei ist,
und dass nach dem Anformen und/oder Anlegen des oder der Mantelelemente (2; 2a, 2b) an den Innendraht (1) eine Wärmebehandlung erfolgt, durch die das zinnhaltige Lot (11) aufgeschmolzen wird,
insbesondere wobei das eine oder die mehreren Mantelelemente (2; 2a, 2b), die in dem kontinuierlichen oder quasi-kontinuierlichen Prozess eingesetzt werden, zumindest an einem Teil ihrer Mantelelement-Enden (5a-5d; 15a-15d) mit einem zinnhaltigen Lot (11) beschichtet worden sind, und/oder wobei vor oder beim Anformen und/oder Anlegen des oder der Mantelelemente (2; 2a, 2b) an den Innendraht (1) eine Folie (14) aus einem zinnhaltigen Lot (11) zwischen die Mantelelement-Enden (5a-5d; 15a-15d) eingelegt wird.

9. Verfahren nach einem der Ansprüche 1 bis 8, **dadurch gekennzeichnet, dass** in dem kontinuierlichen oder quasi-kontinuierlichen Prozess lediglich ein Mantelelement (2) eingesetzt wird,
und dass das Mantelelement (2) um den Innendraht (1) herum geformt wird.

10. Verfahren nach einem der Ansprüche 1 bis 8, **dadurch gekennzeichnet, dass** in dem kontinuierlichen oder quasi-kontinuierlichen Prozess zwei als Halbschalen vorgeformte Mantelelemente (2a, 2b) eingesetzt werden,
und dass die Halbschalen an den Innendraht (1) angelegt werden.

11. Verfahren nach einem der vorhergehenden Ansprüche, **dadurch gekennzeichnet, dass** der Supraleiterdraht (10) einem Umform- oder Ziehprozess unterzogen wird, nachdem der Innendraht (1) mit der Stabilisierungsstruktur (9) versehen worden ist.

12. Verfahren nach Anspruch 11, **dadurch gekennzeichnet, dass** durch den Umform- oder Ziehprozess ein näherungsweise rechteckiger oder näherungsweiser runder Querschnitt des Supraleiterdrahts (10) eingestellt wird.

13. Verfahren nach einem der vorhergehenden Ansprüche, **dadurch gekennzeichnet, dass** der Supraleiterdraht (10) mit einem elektrisch isolierenden Lack (21) beschichtet wird, nachdem der Innendraht (1) mit der Stabilisierungsstruktur (9) versehen worden ist.

14. Verfahren nach einem der vorhergehenden Ansprüche, **dadurch gekennzeichnet, dass** das oder die Mantelelemente (2; 2a, 2b) aus Kupfer, Stahl, Aluminium oder Legierungen von Kupfer, Eisen und/oder Aluminium gefertigt sind.

15. Supraleiterdraht (10), umfassend einen Innendraht (1), der supraleitende Filamente (4) enthält, und eine normalleitende Stabilisierungsstruktur (9),
wobei die Stabilisierungsstruktur (9) den Innendraht (1) über seinen gesamten Umfang umhüllt, wobei die Stabilisierungsstruktur (9) ein oder mehrere Mantelelemente (2; 2a, 2b) umfasst,
wobei der Supraleiterdraht (10) eine oder mehrere, sich über die gesamte Länge des Supraleiterdrahts (10) erstreckende Nähte (16; 16a, 16b) von einander gegenüberliegenden Mantelelement-Enden (15a-15d) aufweist,
und wobei alle Nähte (16; 16a, 16b) von einander gegenüberliegenden Mantelelement-Enden (15a-15d) verlötet und/oder verschweißt sind,
**dadurch gekennzeichnet,**
**dass** im Querschnitt alle Nähte (16; 16a, 16b) von einander gegenüberliegenden Mantelelement-Enden (15a-15d) schräg zur lokalen Innendraht-Oberfläche und schräg zur lokalen Mantelelement-Oberfläche verlaufen,
und **dass** alle schräg zur lokalen Innendraht-Oberfläche und schräg zur lokalen Mantelelement-Oberfläche verlaufenden Nähte (16; 16a, 16b) im Querschnitt jeweils wenigstens zweimal so lang sind wie die Dicke (D) der Mantelelement-Enden (15a-15d) senkrecht zur Oberfläche der Mantelelement-Enden (15a-15d).

16. Supraleiterdraht (10) nach Anspruch 15, **dadurch gekennzeichnet, dass** der Innendraht (1) einen runden Querschnitt aufweist und die Stabilisierungsstruktur (9) einen runden Außenquerschnitt aufweist, und die Stabilisierungsstruktur (9) im Querschnitt eine einheitliche Dicke (D) aufweist.

17. Supraleiterdraht (10) nach Anspruch 15 oder 16, **dadurch gekennzeichnet, dass** am im Querschnitt äußeren Ende einer jeden Naht (6; 6a, 6b; 16; 16a, 16b) die Mantelelement-Enden (5a-5d; 15a-15d) miteinander verschweißt sind.

18. Supraleiterdraht (10) nach einem der Ansprüche 15 bis 17, **dadurch gekennzeichnet, dass** zwischen dem Innendraht (1) und dem oder den Mantelelementen (2; 2a, 2b) und/oder zwischen den einander gegenüberliegenden Mantelelement-Enden (5a-5d; 15a-15d) ein zinnhaltiges Lot (11), insbesondere ein bleifreies zinnhaltiges Lot (11), angeordnet ist.

19. Supraieiterdraht (10) nach einem der Ansprüche 15 bis 18, **dadurch gekennzeichnet, dass** die Stabilisierungsstruktur (9) zwei Mantelelemente (2a, 2b) umfasst, die über zwei Nähte (6a, 6b; 16a, 16b) miteinander verlötet und/oder verschweißt sind.

## Claims

1. Method for producing a superconducting wire (10), wherein an internal wire (1), which contains superconducting filaments (4), is provided with a normally conducting stabilizing structure (9), wherein in a continuous or quasi-continuous process, one or more sheath elements (2; 2a, 2b) is/are shaped and/or placed around the internal wire (9), so that the entire circumference of the internal wire (1) is enclosed by the one or more sheath elements (2; 2a, 2b), and wherein all seams (16; 16a, 16b) of sheath element ends (15a-15d) facing one another are soldered and/or welded,
**characterized in that**
in the continuous or quasi-continuous process, the one or more sheath element(s) (2; 2a, 2b) is/are selected and shaped and/or placed around the internal wire (1) in such a way that, seen in cross section, all seams (16; 16a, 16b) of sheath element ends (15a-15d) facing one another extend obliquely with respect to the local internal wire surface and obliquely with respect to the local sheath element surface, and that all seams (16; 16a, 16b) that extend obliquely with respect to the local internal wire surface and obliquely with respect to the local sheath element surface are, as seen in cross section, at least twice as long as the thickness (D) of the sheath element ends (15a-15d) perpendicular to the surface of the sheath element ends (15a-15d).

2. Method according to claim 1, **characterized in that** the internal wire (1) is selected to have a circular cross section and the one or more sheath element(s) (2; 2a, 2b) is/are selected and shaped and/or placed around the internal wire (1) in such a way that the stabilizing structure (9) has a circular outer cross section and the stabilizing structure (9) has a uniform thickness (D) as seen in cross section.

3. Method according to any one of the previous claims, **characterized in that**, as seen in cross section, the sheath element ends (5a-5d; 15a-15d) at the outer end of each seam (6; 6a, 6b; 16; 16a, 16b) are welded to each other, in particular by laser welding.

4. Method according to any one of the previous claims, **characterized in that** a non-twisted internal wire (1) is used in the continuous or quasi-continuous process in such a way that all seams (6; 6a, 6b; 16; 16a, 16b) extend parallel to the superconducting filaments (4) of the internal wire (1),
and that the superconducting wire (10) is twisted after the internal wire (1) has been provided with the stabilizing structure (9).

5. Method according to any one of the previous claims, **characterized in that**,
as part of the continuous or quasi-continuous process, a solid solder containing tin (11) is inserted between the sheath element(s) (2; 2a, 2b) and the internal wire (1),
in particular wherein the solid solder containing tin (11) is lead-free,
and that shaping and/or placing the sheath element(s) (2; 2a, 2b) around the internal wire (1) is followed by heat treatment, which melts the solder containing tin (11).

6. Method according to claim 5, **characterized in that** the one or more sheath element(s) (2; 2a, 2b) that is/are used in the continuous or quasi-continuous process are coated with solder containing tin (11) on their side facing the internal wire (1).

7. Method according to either one of the claims 5 or 6, **characterized in that** a foil (13) made of a solder containing tin (11) is placed between the sheath element(s) (2; 2a, 2b) and the internal wire (1) before or while the sheath element(s) (2; 2a, 2b) are shaped and/or placed around the internal wire (9).

8. Method according to any one of the previous claims, **characterized in that**, during the continuous or quasi-continuous process, a solid solder containing tin (11) is inserted between the sheath element ends (5a-5d; 15a-15d),
in particular wherein the solid solder containing tin (11) is lead-free,
and that after shaping and/or placing the sheath element(s) (2; 2a, 2b) around the internal wire (1), a heat treatment is performed by which the solder containing tin (11) is melted,
in particular wherein the one or more sheath element(s) (2; 2a, 2b) used in the continuous or quasi-continuous process is/are coated, at least on a part of their sheath element ends (5a-5d; 15a-15d), with a solder containing tin (11), and/or wherein before or during shaping and/or placing the sheath element(s) (2; 2a, 2b) around the internal wire (1), a foil (14) made of solder containing tin (11) is inserted between the sheath element ends (5a-5d; 15a-15d).

9. Method according to any one of the claims 1 to 8, **characterized in that**
only one sheath element (2) is used in the continuous or quasi-continuous process,
and that the sheath element (2) is shaped around the internal wire (1).

10. Method according to any one of the claims 1 to 8, **characterized in that**
two sheath elements (2a, 2b) preshaped as half-shells are used in the continuous or quasi-continuous process,
and that the half-shells are placed around the internal wire (1).

11. Method according to any one of the previous claims, **characterized in that** the superconducting wire (10) is subjected to a reshaping or drawing process after the internal wire (1) has been provided with the stabilizing structure (9).

12. Method according to claim 11, **characterized in that** the reshaping or drawing process ensures that an approximately rectangular or approximately circular cross section of the superconducting wire (10) is implemented.

13. Method according to any one of the previous claims, **characterized in that** the superconducting wire (10) is coated with an electrically insulating paint (21) after the internal wire (1) has been provided with the stabilizing structure (9).

14. Method according to any one of the previous claims, **characterized in that** the sheath element(s) (2; 2a, 2b) is/are made of copper, steel, aluminum, or alloys of copper, iron, and/or aluminum.

15. Superconducting wire (10), comprising an internal wire (1), which contains superconducting filaments (4), and a normally conducting stabilizing structure (9),
wherein the stabilizing structure (9) encloses the internal wire (1) around its entire circumference, wherein the stabilizing structure (9) comprises one or more sheath element(s) (2; 2a, 2b),
wherein the superconducting wire (10) has one or more seams (16; 16a, 16b) of sheath element ends (15a-15d) facing one another, which extend along the entire length of the superconducting wire (10),
and wherein all seams (16; 16a, 16b) of sheath element ends (15a-15d) facing one another are soldered and/or welded,
**characterized in that**,
seen in cross section, all seams (16; 16a, 16b) of sheath element ends (15a-15d) facing one another extend obliquely relative to the local internal wire surface and obliquely with respect to the local sheath element surface,
and that all seams (16; 16a, 16b) that extend obliquely with respect to the local internal wire surface and obliquely with respect to the local sheath element surface are at least twice as long as the thickness (D) of the sheath element ends (15a-15d) perpendicular to the surface of the sheath element ends (15a-15d) as seen in cross section.

16. Superconducting wire (10) according to claim 15, **characterized in that** the internal wire (1) has a circular cross section and the stabilizing structure (9) has a circular outer cross section and the stabilizing structure (9) has a uniform thickness (D) as seen in cross section.

17. Superconducting wire (10) according to claim 15 or 16, **characterized in that**, as seen in cross section, the sheath element ends (5a-5d; 15a-15d) are welded to each other at the outer end of each seam (6; 6a, 6b; 16; 16a, 16b).

18. Superconducting wire (10) according to any one of the claims 15 to 17, characterized that a solder containing tin (11), in particular a lead-free solder containing tin (11), is disposed between the internal wire (1) and the sheath element(s) (2; 2a, 2b) and/or between the sheath element ends (5a-5d; 15a-15d) facing one another.

19. Superconducting wire (10) according to any one of the claims 15 to 18, **characterized in that** the stabilizing structure (9) comprises two sheath elements (2a, 2b), which are soldered and/or welded to each other with two seams (6a, 6b; 16a, 16b).

## Revendications

1. Procédé de fabrication d'un fil supraconducteur (10),
dans lequel un fil intérieur (1) contenant des filaments supraconducteurs (4) est pourvu d'une structure de stabilisation normalement conductrice (9),
dans lequel un ou plusieurs éléments de gaine (2 ; 2a, 2b) sont formés et/ou appliqués sur le fil intérieur (9) dans un procédé continu ou quasi continu, de sorte que le fil intérieur (1) est enveloppé sur toute sa circonférence par lesdits un ou plusieurs éléments de gaine (2 ; 2a, 2b), et dans lequel tous les joints (16 ; 16a, 16b) d'extrémités d'éléments de gaine se faisant face (15a-15d) sont brasés et/ou soudés,
**caractérisé en ce**
**que**, dans le procédé continu ou quasi continu, lesdits un ou plusieurs éléments de gaine (2 ; 2a, 2b) sont choisis et formés et/ou appliqués sur le fil intérieur (1) de telle sorte que, en section transversale, tous les joints (16 ; 16a, 16b) d'extrémités d'éléments de gaine se faisant face (15a-15d) s'étendent obliquement par rapport à la surface de fil intérieur locale et obliquement par rapport à la surface d'élément de gaine locale,
et **que** tous les joints (16 ; 16a, 16b) s'étendant obliquement par rapport à la surface de fil intérieur locale et obliquement par rapport à la surface d'élément de gaine locale sont chacun, en section transversale, au moins deux fois plus longs que l'épaisseur (D) des extrémités d'éléments de gaine (15a-15d) perpendiculairement à la surface des extrémités d'éléments de gaine (15a-15d).

2. Procédé selon la revendication 1, **caractérisé en ce que** le fil intérieur (1) est choisi avec une section transversale ronde et lesdits un ou plusieurs éléments de gaine (2 ; 2a, 2b) sont sélectionnés et formés et/ou appliqués sur le fil intérieur (1) de telle sorte que la structure de stabilisation (9) présente une section transversale extérieure ronde, et la structure de stabilisation (9) présente une épaisseur uniforme (D) en section transversale.

3. Procédé selon l'une des revendications précédentes, **caractérisé en ce que** les extrémités d'éléments de gaine (5a-5d ; 15a-15d) sont soudées entre elles, en particulier par soudage au laser, à l'extrémité extérieure en section transversale de chaque joint (6 ; 6a, 6b ; 16 ; 16a, 16b).

4. Procédé selon l'une des revendications précédentes, **caractérisé en ce que** dans le procédé continu ou quasi continu, on utilise un fil intérieur (1) non torsadé, de sorte que tous les joints (6 ; 6a, 6b ; 16 ; 16a, 16b) s'étendent parallèlement aux filaments supraconducteurs (4) du fil intérieur (1),
et que le fil supraconducteur (10) est torsadé après que le fil intérieur (1) a été pourvu de la structure de stabilisation (9).

5. Procédé selon l'une des revendications précédentes, **caractérisé en ce que**, dans le cadre du processus continu ou quasi continu, un métal d'apport solide contenant de l'étain (11) est introduit entre lesdits un ou plusieurs éléments de gaine (2 ; 2a, 2b) et le fil intérieur (1), en particulier dans lequel le métal d'apport solide contenant de l'étain (11) est exempt de plomb,
et qu'après le formage et/ou l'application du ou des éléments de gaine (2 ; 2a, 2b) sur le fil intérieur (1), on effectue un traitement thermique par lequel le métal d'apport contenant de l'étain (11) est fondu.

6. Procédé selon la revendication 5, **caractérisé en ce que** lesdits un ou plusieurs éléments de gaine (2 ; 2a, 2b) qui sont utilisés dans le procédé continu ou quasi continu ont été revêtus d'un métal d'apport contenant de l'étain (11) sur leur face tournée vers le fil intérieur (1).

7. Procédé selon l'une des revendications 5 ou 6, **caractérisé en ce qu'**avant ou pendant le formage et/ou l'application du ou des éléments de gaine (2 ; 2a, 2b) sur le fil intérieur (9), une feuille (13) d'un métal d'apport contenant de l'étain (11) est insérée entre le ou les éléments de gaine (2 ; 2a, 2b) et le fil intérieur (1).

8. Procédé selon l'une des revendications précédentes, **caractérisé en ce que**, dans le cadre du procédé continu ou quasi continu, un métal d'apport solide contenant de l'étain (11) contenant de l'étain est introduit entre les extrémités d'éléments de gaine (5a-5d ; 15a-15d), en particulier dans lequel le métal d'apport solide contenant de l'étain (11) est exempt de plomb,
et qu'après le formage et/ou l'application du ou des éléments de gaine (2 ; 2a, 2b) sur le fil intérieur (1), on effectue un traitement thermique par lequel le métal d'apport contenant de l'étain (11) est fondu,
en particulier dans lequel lesdits un ou plusieurs éléments de gaine (2 ; 2a, 2b) qui sont utilisés dans le procédé continu ou quasi continu ont été revêtus d'un métal d'apport contenant de l'étain (11) au moins sur une partie de leurs extrémités d'éléments de gaine (5a-5d; 15a-15d), et/ou dans lequel, avant ou pendant le formage et/ou l'application du ou des éléments de gaine (2 ; 2a, 2b) sur le fil intérieur (1), une feuille (14) d'un métal d'apport contenant de l'étain (11) est insérée entre les extrémités d'éléments de gaine (5a-5d ; 15a-15d).

9. Procédé selon l'une des revendications 1 à 8, **caractérisé en ce qu'**un seul élément de gaine (2) est utilisé dans le processus continu ou quasi continu,
et que l'élément de gaine (2) est formé autour du fil intérieur (1).

10. Procédé selon l'une des revendications 1 à 8, **caractérisé en ce que** deux éléments de gaine (2a, 2b) préformés sous la forme de demi-coques sont utilisés dans le procédé continu ou quasi continu,
et que les demi-coques sont appliquées sur le fil intérieur (1).

11. Procédé selon l'une des revendications précédentes, **caractérisé en ce que** le fil supraconducteur (10) est soumis à un processus de formage ou d'étirage après que le fil intérieur (1) a été pourvu de la structure de stabilisation (9).

12. Procédé selon la revendication 11, **caractérisé en ce qu'**une section transversale approximativement rectangulaire ou ronde du fil supraconducteur (10) est obtenue par le procédé de formage ou d'étirage.

13. Procédé selon l'une des revendications précédentes, **caractérisé en ce que** le fil supraconducteur (10) est revêtu d'un vernis électriquement isolant (21) après que le fil intérieur (1) a été pourvu de la structure de stabilisation (9).

14. Procédé selon l'une des revendications précédentes, **caractérisé en ce que** le ou les éléments de gaine (2 ; 2a, 2b) sont constitués de cuivre, d'acier, d'aluminium ou d'alliages de cuivre, de fer et/ou d'aluminium.

15. Fil supraconducteur (10), comprenant un fil intérieur (1) contenant des filaments supraconducteurs (4) et une structure de stabilisation normalement conductrice (9), la structure de stabilisation (9) enveloppant le fil intérieur (1) sur toute sa circonférence, la structure de stabilisation (9) comprenant un ou plusieurs éléments de gaine (2 ; 2a, 2b),
dans lequel le fil supraconducteur (10) présente un ou plusieurs joints (16 ; 16a, 16b) d'extrémités d'éléments de gaine se faisant face (15a-15d), qui s'étendent sur toute la longueur du fil supraconducteur (10),
et dans lequel tous les joints (16 ; 16a, 16b) d'extrémités d'éléments de gaine se faisant face (15a-15d) sont brasés et/ou soudés,
**caractérisé en ce**
**que**, en section transversale, tous les joints (16 ; 16a, 16b) d'extrémités d'éléments de gaine se faisant face (15a-15d) s'étendent obliquement par rapport à la surface de fil intérieur locale et obliquement par rapport à la surface d'élément de gaine locale,
et **que** tous les joints (16 ; 16a, 16b) s'étendant obliquement par rapport à la surface de fil intérieur locale et obliquement par rapport à la surface d'élément de gaine locale sont chacun, en section transversale, au moins deux fois plus longs que l'épaisseur (D) des extrémités d'éléments de gaine (15a-15d) perpendiculairement à la surface des extrémités d'éléments de gaine (15a-15d).

16. Fil supraconducteur (10) selon la revendication 15, **caractérisé en ce que** le fil intérieur (1) présente une section transversale ronde et la structure de stabilisation (9) présente une section transversale extérieure ronde, et la structure de stabilisation (9) présente une épaisseur uniforme (D) en section transversale.

17. Fil supraconducteur (10) selon la revendication 15 ou 16, **caractérisé en ce que** les extrémités d'éléments de gaine (5a-5d ; 15a-15d) sont soudées entre elles à l'extrémité extérieure en section transversale de chaque joint (6 ; 6a, 6b ; 16 ; 16a, 16b).

18. Fil supraconducteur (10) selon l'une des revendications 15 à 17, **caractérisé en ce qu'**un métal d'apport contenant de l'étain (11), en particulier un métal d'apport contenant de l'étain (11) exempt de plomb, est disposé entre le fil intérieur (1) et le ou les éléments de gaine (2 ; 2a, 2b) et/ou entre les extrémités d'éléments de gaine se faisant face (5a-5d ; 15a-15d).

19. Fil supraconducteur (10) selon l'une des revendications 15 à 18, **caractérisé en ce que** la structure de stabilisation (9) comprend deux éléments de gaine (2a, 2b) qui sont brasés et/ou soudés ensemble par deux joints (6a, 6b ; 16a, 16b).
